# EUROPÄISCHE PATENTSCHRIFT

(11) **EP 2 308 117 B1**
(45) Veröffentlichungstag und Bekanntmachung des Hinweises auf die Patenterteilung: **11.12.2019**
(21) Anmeldenummer: 09775996.3
(22) Anmeldetag: 21.07.2009
(51) Int. Cl.: H01L 51/52

(54) **STRAHLUNGSEMITTIERENDE VORRICHTUNG UND VERFAHREN ZUR HERSTELLUNG EINER STRAHLUNGSEMITTIERENDEN VORRICHTUNG**
RADIATION-EMITTING DEVICE AND METHOD FOR PRODUCING A RADIATION-EMITTING DEVICE
DISPOSITIF ÉMETTANT UN RAYONNEMENT ET PROCÉDÉ DE FABRICATION D'UN DISPOSITIF ÉMETTANT UN RAYONNEMENT

(30) Priorität: 25.07.2008 DE 102008034717; 27.10.2008 DE 102008053326
(43) Veröffentlichungstag der Anmeldung: 13.04.2011
(73) Patentinhaber: OSRAM OLED GmbH, 93049 Regensburg (DE)
(72) Erfinder: KLEIN, Markus, 93105 Tegernheim (DE); SCHLENKER, Tilman, 93152 Nittendorf (DE); INGLE, Andrew, 85391 Allershausen (DE)
(74) Vertreter: Epping - Hermann - Fischer
(86) Internationale Anmeldenummer: PCT/DE2009/001022
(87) Internationale Veröffentlichungsnummer: WO 2010/009716

(56) Entgegenhaltungen:
- WO-A-02/065204
- US-A1- 2003 124 392
- US-A1- 2007 128 966
- X. T. HAO ET AL.: "Top emitting poly(p-phenylene vinylene) light-emitting diodes on metal sandwiched polyethylene terephtalate substrates" APPLIED PHYSICS B, Bd. 83, 18. Januar 2006 (2006-01-18), Seiten 67-74, XP002572946 AIP, USA

## Beschreibung

Die Erfindung betrifft eine strahlungsemittierende Vorrichtung und ein Verfahren zur Herstellung einer strahlungsemittierenden Vorrichtung.

Diese Patentanmeldung beansprucht die Prioritäten der deutschen Patentanmeldung DE 10 2008 034 717.5 und der deutschen Patentanmeldung DE 10 2008 053 326.2. Strahlungsemittierende Vorrichtungen, wie beispielsweise elektrolumineszente, organische Leuchtdioden, weisen ein Substrat auf, auf dem eine organische Schichtenfolge zwischen einer ersten und zweiten Elektrode angeordnet ist. Die Dokumente US 2003/124392, WO 02/065204 und X.T. Hao et al. in "Top emitting poly(p-phenylene vinylene) light-emitting diodes on metal sandwiched polyethylene terephthalate substrates" offenbaren organische Leuchtdioden (OLEDs) auf einer metallbeschichteten Kunststofffolie. US 2007/128966 offenbart eine OLED mit Elektrodenkontakten die aus der Verkapselungsstruktur hinausragen.

Aufgabe der Erfindung ist es, eine strahlungsemittierende Vorrichtung bereitzustellen, die ein Substrat mit verbesserten Eigenschaften umfasst. Eine weitere Aufgabe der Erfindung ist es, ein Verfahren bereitzustellen, mit dem eine solche strahlungsemittierende Vorrichtung hergestellt werden kann. Diese Aufgaben werden durch eine Vorrichtung gemäß dem Patentanspruch 1 und durch ein Verfahren gemäß dem Patentanspruch 7 gelöst. Weitere Ausführungsformen der Vorrichtung und des Verfahrens sind Gegenstand abhängiger Patentansprüche.

Gemäß einer Ausführungsform wird eine strahlungsemittierende Vorrichtung nach Anspruch 1 bereitgestellt.

Damit kann eine strahlungsemittierende Vorrichtung, beispielsweise eine flexible, organische Licht emittierende Diode (OLED), bereitgestellt werden, die ein Substrat umfasst, das günstig herzustellen ist und das die auf dem Substrat angeordneten Schichten vor Sauerstoff und Feuchte schützt.

Das Substrat ist weiterhin frei von Barriereschichten. Weiterhin kann das Substrat flexibel ausgeformt sein und eine flexible, nicht rigide Kunststofffolie umfassen. Die Bereitstellung der Kunststofffolie ist mit geringen Kosten verbunden, zudem können Kunststofffolien eine geringe Oberflächenrauhigkeit aufweisen. Weiterhin kann durch die Verwendung von Substraten, die Kunststofffolien, auf denen ein Metallfilm angeordnet ist, umfassen, darauf verzichtet werden, die Kunststofffolie beispielsweise mittels einer Barriereschicht gegen Diffusion von Sauerstoff oder Feuchtigkeit abzudichten, da auf ihr ein Metallfilm angeordnet wird. Dieser kann hermetisch und intrinsisch diffusionsdicht sein und somit eine Diffusion von Sauerstoff oder Wasser (in Form von Feuchtigkeit) durch das Substrat hindurch verhindern. Somit wird ein günstiges und zugleich diffusionsdichtes Substrat für eine beispielsweise flexible strahlungsemittierende Vorrichtung bereitgestellt, das zudem im Falle der flexiblen Ausgestaltung Rolle-zu-Rolle-tauglich ist. "Rolle-zu-Rolle tauglich" wird so verstanden, dass das Substrat so ausgeformt ist, dass es von einer Walze abgerollt werden kann, mit weiteren Schichten bedruckt und wieder aufgerollt werden kann.

Der Metallfilm kann dabei auf die Kunststofffolie aufgedampft, gesputtert oder mit anderen Methoden aufgebracht werden. Dadurch, dass der dichte Metallfilm auf die Kunststofffolie aufgebracht wird, muss keine zusätzliche Barriereschicht aufgebracht werden, die eine Diffusion durch die Kunststofffolie hindurch verhindert.

Weiterhin kann auf die Anordnung einer zusätzlichen Elektrode auf dem Substrat verzichtet werden, da der Metallfilm als erste Elektrode eingerichtet ist.

"Eingerichtet" bedeutet in diesem Zusammenhang, dass der erste Metallfilm mit einem äußeren, elektrischen Anschluss kontaktierbar ist, und elektrisch leitend mit den auf dem Substrat angeordneten organischen funktionellen Schichten verbunden ist. Der Metallfilm kann dabei zusätzlich eine strukturierte Oberfläche aufweisen, die die Injektion von Ladungsträgern in die zumindest eine organische funktionelle Schicht beeinflussen kann.

Weiterhin kann der Metallfilm die gleichen lateralen Ausdehnungen wie die Kunststofffolie aufweisen. Soll das Substrat von den auf dem Substrat angeordneten Schichten in Bereichen isoliert sein, kann der Metallfilm in diesen Bereichen Aussparungen aufweisen.

Das Substrat kann weiterhin eine größere laterale Ausdehnung aufweisen, als die zumindest eine organische funktionelle Schicht und die zweite Elektrode. Damit kann sich das Substrat, das die Kunststofffolie und den Metallfilm umfasst, über den aktiven Bereich, das heißt über die von der zumindest einen organischen funktionellen Schicht und der zweiten Elektrode begrenzten Fläche hinaus erstrecken. Das Substrat kann eine Fläche aufweisen, die auf allen Seiten der von der zumindest einen organischen funktionellen Schicht und der zweiten Elektrode begrenzten Fläche hinaus reicht. Damit kann das Substrat, umfassend die Kunststofffolie und den Metallfilm, Bereiche aufweisen, die nicht von der zumindest einen organischen funktionellen Schicht bedeckt ist und auf die weitere funktionale Schichten, beispielsweise Isolationsschichten oder Verkapselungsschichten, aufgebracht werden können.

Der Metallfilm ist weiterhin diffusionsdicht. Diffusionsdicht bedeutet in diesem Zusammenhang, hermetisch und intrinsisch dicht gegenüber Sauerstoff und Wasser, auch in Form von Feuchtigkeit. Das bedeutet, dass die Diffusion von Sauerstoff und/oder Wasser durch den Metallfilm hindurch mit für diesen Zweck verfügbaren Messmethoden nicht mehr detektiert werden kann. Durch den Metallfilm diffundiert also für einen langen Zeitraum, beispielsweise mehrere Jahre, keine messbare Menge an Sauerstoff und/oder Wasser. Damit werden die auf dem Substrat angeordneten, Sauerstoff- und Wasserempfindlichen organischen funktionellen Schichten durch den Metallfilm vor Sauerstoff und Wasser geschützt, was zu einer Verlängerung ihrer Lebensdauer führt.

Die Dichtigkeit des Metallfilms besteht dabei nicht nur aus einer intrinsischen Dichtheit auf kleinen Flächen, sondern es sind auch keine oder nur sehr wenige Korngrenzen, Poren und Kanälen vorhanden, durch die Sauerstoff oder Wasser diffundieren könnte. Das bedeutet unter anderem, dass der dichte Metallfilm keine oder sehr wenige Punkteffekte aufweist. Damit wird die Entstehung von so genannten Black Spots vermieden und die Effizienz der Vorrichtung erhöht. Um festzustellen, ob der Metallfilm diffusionsdicht ist, kann die fertige strahlungsemittierende Vorrichtung einem Lebensdauertest unterzogen werden. Dazu wird die Vorrichtung in einen Feuchteofen gestellt, und für 3 bis 6 Wochen extrem hohen Werten von Sauerstoff und Wasser in Form von Luftfeuchtigkeit ausgesetzt. Diese beschleunigte Messung der Diffusion durch das Substrat hindurch kann auf die Lebensdauer der Vorrichtung unter normalen Bedingungen extrapoliert werden.

Somit kann eine strahlungsemittierende Vorrichtung, die flexibel ausgestaltet sein kann, mit einem Substrat, das eine Kunststofffolie und einen dichten Metallfilm aufweist, eine Lebensdauer von 8 bis 12 Jahren aufweisen.

Die Kunststofffolie kann weiterhin weniger diffusionsdicht als der Metallfilm sein. Kunststofffolien haben im Allgemeinen schlechtere Barriereeigenschaften als dichte Metallfilme, das heißt, sie weisen eine Diffusion von Sauerstoff und Wasser auf. Um sie dennoch in der strahlungsemittierenden Vorrichtung, die flexibel ausgestaltet sein kann, in dem Substrat verwenden zu können, kann darauf verzichtet werden, sie beispielsweise durch eine Barriereschicht für Sauerstoff und Wasser diffusionsdicht zu machen, da auf ihnen ein Metallfilm, der intrinsisch und hermetisch diffusionsdicht ist, angeordnet ist. Damit können Kosten und Aufwand für die Bereitstellung des Substrats gespart werden.

Die Kunststofffolie kann ein Material aufweisen, das aus einer Gruppe ausgewählt ist, die Polyester, Polyethylen (PE), Polypropylen (PP), Polyvinylchlorid (PVC), Polystyrol (PS), Polyvinylidenchlorid (Saran), Ethylenvinylalkohol (EVA), Cellophan, Cellulose, Polyactide (PLA), Polyamid, Polyimid (PI), Polycarbonate (PC), Polyacrylate sowie Mischungen daraus umfasst.

Beispiele für Polyester sind PET (Polyethylenterephthalat), Mylar (BOPET: biaxial orientiertes Polyethylenteraphthalat) oder PES (Polyethersulfon). Ein Polyacrylat ist beispielsweise PMMA (Polymethylmethacrylat). Polyethylen kann als stark verzweigtes Polyethylen mit einer geringen Dichte (LDPE) oder als wenig verzweigtes Polyethylen mit einer hohen Dichte (HDPE) eingesetzt werden.

Diese Materialien können die Eigenschaft aufweisen, dass sie zu Folien gezogen, geblasen, extrudiert oder mittels anderer Methoden zu Folien verarbeitet werden können.

Durch die Kombination dieser Materialien mit Metallfilmen, werden Probleme von Kunststofffolien, die ohne Metallfilm nicht als Substrat verwendet werden, wie beispielsweise, thermische Verformungen, Schwellen und Schrumpfen durch Feuchtigkeitsaufnahme oder mechanische Verformungen vermieden. Durch die verbesserten Eigenschaften des Substrats, das eine Kunststofffolie und einen Metallfilm umfasst, kann die Langzeitstabilität der strahlungsemittierenden Vorrichtung erhöht werden und Qualitätseinbrüche vermieden werden.

Weiterhin kann zwischen der Kunststofffolie und dem Metallfilm eine Planarisierungsschicht angeordnet sein. Die Planarisierungsschicht weist eine Dicke auf, die so groß ist, dass mögliche Oberflächenrauhigkeiten der Kunststofffolie und des Metallfilms ausgeglichen werden können. Da organische Schichten einer strahlungsemittierenden Vorrichtung typischerweise wenige 10 nm dick sind, wirken sich Oberflächenrauhigkeit durch mehrere Schichten hindurch aus. Durch die Verwendung einer Planarisierungsschicht können diese Auswirkungen der Oberflächenrauhigkeiten durch mehrere Schichten hindurch reduziert oder vermieden werden. Weiterhin kann die Planarisierungsschicht dazu beitragen, dass die Haftung zwischen der Kunststofffolie und dem Metallfilm verbessert ist.

Die Planarisierungsschicht kann ein Material aufweisen, das aus einer Gruppe ausgewählt ist, die Polyimide, Polyamide, Polysiloxane, Epoxyharze, Polyurethane, BCB, Acryle und weitere Polymere mit niedriger dielektrischer Konstante, anorganische Oxide und Kombinationen davon aufweisen. Anorganische Oxide können aus einem Sol-Gel-Prozess erhalten werden, in dem Gele aus kolloidalen Dispersionen hergestellt werden, und beispielsweise Spin-on-Gläser oder im Vakuum abgeschiedene anorganische Oxide umfassen. Unter Spin-on-Gläsern werden Polysiloxane oder andere Siloxane verstanden, die in einem Lösungsmittel gelöst sind, und als Lösung aufgebracht und bei hohen Temperaturen gehärtet werden. Dabei wird ein glasartiges Material mit hohem SiO₂-Anteil gebildet.

Neben diesem Materialien zur Planarisierung können auch selbst organisierende Monolagen (englisch: self-assembling monolayers, SAM) verwendet werden, die zudem eine elektrische Isolierung darstellen können. Selbst organisierende Monolagen sind Schichten hoher Ordnung und bilden sich spontan beim Eintauchen von oberflächenaktiven und/oder organischen Substanzen in eine Lösung. Generell muss die Planarisierungsschicht nicht diffusionsdicht ausgeformt sein, da sie zwischen der Kunststofffolie und dem dichten Metallfilm angeordnet ist. Durch die Kombination von einer flexiblen Kunststofffolie, Planarisierungsschicht und Metallfilm kann ein flexibles Substrat bereitgestellt werden, das diffusionsdicht und Rolle-zu-Rolle-tauglich ist. Dieses Substrat ist weiterhin günstig herstellbar, im Gegensatz zu Metallfolien, die, wenn sie als Substrat verwendet werden, eine teure Fertigungstechnik und eine hohe Rauhigkeit ihrer Oberfläche aufweisen.

Weiterhin weist die strahlungsemittierende Vorrichtung auf der zweiten Elektrode und auf dem Substrat eine Glas- und/oder Dünnfilmverkapselung zur Verkapselung der zumindest einen organischen funktionellen Schicht auf. Die Dünnfilmverkapselung kann eine dünne Schicht sein, die die organischen Schichten vollständig umgibt. Somit wird eine flexible Verkapselung der strahlungsemittierenden Vorrichtung bereitgestellt, die ein Eindiffundieren von Sauerstoff und/oder Wasser, auch in Form von Feuchtigkeit, von allen Seiten verhindert. Die Verkapselung kann dazu hermetisch und intrinsisch dicht gegenüber Sauerstoff und Wasser sein und keine Punkteffekte aufweisen.

Bei einer strahlungsemittierenden Vorrichtung mit den oben genannten Eigenschaften ist die zumindest eine organische funktionelle Schicht und die zweite Elektrode auf dem Substrat angeordnet, das einen Metallfilm aufweist, sodass das durch die Vorrichtung erzeugte Licht nicht durch das Substrat, sondern durch die zweite Elektrode ausgekoppelt wird. Das bedeutet, dass der Metallfilm das Substrat verspiegeln und die Auskopplung des Lichts durch die zweite Elektrode hindurch verbessern kann. Eine solche strahlungsemittierende Vorrichtung wird als Topemitter bezeichnet.

Die Dünnfilm- und/oder Glasverkapselung kann weiterhin transparent sein. Eine Dünnfilmverkapselung kann eine im Plasma-enhanced Chemical Vapour Deposition (PE-CVD)-Verfahren hergestellte SiO₂-Schicht mit einer Dicke von 25 nm bis 500 nm, beispielsweise mit einer Dicke von 100 nm, umfassen. Weiterhin kann eine Dünnfilmverkapselung als Material anorganische Lagen, wie beispielsweise Al₂O₃, TiO₂, ZrO₂, SiO₂, Si₃N₄, SiC oder DLC (Diamond Like Carbon: diamantartige Kohlenstoffschichten) oder Kombinationen dieser Lagen umfassen.

Ist die Verkapselung eine Glasverkapselung, kann diese ein amorphes Glas aufweisen, das beispielsweise durch Elektronenstrahlverdampfung in Schichtdicken von einigen Mikrometern, beispielsweise 3 µm, aufgebracht wird.

Weiterhin kann eine Dünnfilmverkapselung mit einer Glasverkapselung kombiniert werden. Dazu wird eine dünne Glasschicht auf die Dünnfilmverkapselung auflaminiert. Mögliche letzte kleine Poren in der Dünnfilmverkapselung können durch die zusätzliche Glasverkapselung unterdrückt werden. Durch die zusätzliche Glasverkapselung werden die Diffusionswege für Wasser und Sauerstoff um Größenordnungen erhöht und damit die Diffusion verlangsamt. Weiterhin ersetzt die zusätzliche Glasverkapselung auf der Dünnfilmverkapselung zusätzliche funktionale Schichten, beispielsweise Kratz- und Korrosionsschichten. Die Glasverkapselung kann auf der Dünnfilmverkapselung auch ohne Schutzgasumgebung und damit mit geringem Aufwand aufgebracht werden.

Zwischen der zweiten Elektrode und der Verkapselung oder auf der von der zweiten Elektrode abgewandten Seite der Verkapselung können weiterhin zusätzliche Schichten vorhanden sein, die beispielsweise Konversionsleuchtstoffe oder Lichtextraktionsstrukturen aufweisen. Somit kann die Wellenlänge des von der Vorrichtung emittierten Lichtes verändert und/oder verstärkt werden.

Weiterhin kann die Verkapselung auch elektrisch isolierend sein. Dann kann beispielsweise eine Dünnfilmverkapselung aus mehreren Lagen aufweisend eine Schichtenfolge aus SiNₓ, SiO₂, SiNₓ-Schichten umfassen.

Weiterhin kann die zweite Elektrode transparent oder semitransparent ausgeführt sein. Beispielsweise kann die zweite Elektrode eine Transparenz von mehr als 50% aufweisen.

Elektrodenmaterialien, die eine hohe Leitfähigkeit und Transparenz aufweisen, können ausgewählt sein aus transparenten, elektrisch leitenden Oxiden (transparent conductive oxides, kurz "TCO"). Es können auch dünne Metallfilme verwendet werden, die einen besonders geringen Flächenwiderstand aufweisen können. Solche Metallfilme können Dicken in einem Bereich von 10 nm bis 10 µm und einen Flächenwiderstand << 5 Ω/Fläche aufweisen. Im Vergleich dazu weisen eine ITO-Elektrode auf Glas einen Flächenwiderstand von 15 Ω/Fläche und eine Schichtenfolge ITO-Metall-ITO von 5 Ω/Fläche auf. Beispielsweise können auch Mischsysteme, wie Indiumzinnoxid/Metall/Indiumzinnoxid, als Material für die zweite Elektrode bereitgestellt werden.

Transparente, elektrisch leitende Oxide sind transparente, elektrisch leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin kann es möglich sein, dass die TCOs nicht zwingend einer stöchiometrischen Zusammensetzung entsprechen und auch p- oder n-dotiert sein können.

Der Metallfilm, der als erste Elektrode eingerichtet ist, kann ein Material aufweisen, das Aluminium, Kupfer, Chrom, Gold, Platin, Chrom, Molybdän, Silber oder Legierungen dieser Metalle umfasst. Der Metallfilm kann weiterhin zumindest Teilschichten aufweisen, die jeweils eines der Metalle Aluminium, Kupfer, Chrom, Gold, Platin, Chrom, Molybdän, Silber oder Legierungen daraus umfassen und übereinander gestapelt angeordnet sind. Der Metallfilm muss nicht transparent ausgeführt sein, wenn die strahlungsemittierende Vorrichtung ein Topemitter ist.

Zwischen der Glas- und/oder Dünnfilmverkapselung und dem Substrat wird eine strukturierte Isolationsschicht angeordnet. Diese befindet sich nicht im aktiven Bereich der Vorrichtung, das heißt auf Bereichen des Substrats, die von der zumindest einen organischen funktionellen Schicht bedeckt sind. Die Isolationsschicht kann den direkten Kontakt zwischen dem Metallfilm und der zweiten Elektrode elektrisch isolieren. Die Isolationsschicht kann ein Material aufweisen, das aus Al₂O₃, TiO₂, ZrO₂, SiO₂, Si₃N₄, SiC, DLC oder Kombinationen davon ausgewählt ist. Die Isolationsschicht kann weiterhin diffusionsdicht ausgeformt sein und beispielsweise in einem Plasma aufgebracht werden.

Die strahlungsemittierende Vorrichtung kann eine organische Licht emittierende Diode (OLED) umfassen. Die OLED, die auch flexibel ausgestaltet sein kann, kann farbiges oder weißes Licht emittieren. Bei einer OLED ist zumindest eine Licht emittierende Schicht zwischen zwei Elektroden angeordnet. Die Elektroden injizieren Elektronen bzw. Löcher in die Licht emittierende Schicht, wo sie rekombinieren und damit zu der Lichtemission führen.

Es wird weiterhin ein Verfahren zur Herstellung einer strahlungsemittierenden Vorrichtung bereitgestellt, die die oben genannten Eigenschaften aufweist. Das Verfahren umfasst die Verfahrensschritte in Anspruch 7.

Damit wird ein Verfahren bereitgestellt, das die Herstellung einer strahlungsemittierenden Vorrichtung ermöglicht, die ein Substrat aufweist, das eine Kunststofffolie und einen Metallfilm umfasst, wobei der Metallfilm als erste Elektrode ausgestaltet ist, und das Substrat günstig herstellbar ist. Das Verfahren ermöglicht ebenso die Herstellung einer flexiblen strahlungsemittierenden Vorrichtung, die ein Substrat aufweist, das eine flexible Kunststofffolie und einen Metallfilm umfasst, wobei der Metallfilm als erste Elektrode ausgestaltet ist Das Verfahren kann weiterhin den Verfahrensschritt A) mit den Schritten
A1) Herstellen einer Kunststofffolie, und
A2) Anordnen eines Metallfilms auf der Kunststofffolie umfassen. Somit kann ein Substrat hergestellt werden, das eine Kunststofffolie und einen Metallfilm umfassst.

Der Verfahrensschritt A1) umfasst das Ziehen, Extrodieren oder Blasen eines Materials für die Kunststofffolie. Zur Herstellung der Kunststofffolie sind weitere Herstellungsmethoden denkbar. Es wird somit in einfacher Weise eine Kunststofffolie für das Substrat bereitgestellt. Die Kunststofffolie kann auch flexibel ausgeformt werden.

Weiterhin kann im Verfahrensschritt A2) ein Material für den Metallfilm auf die Kunststofffolie aufgedampft werden. Somit wird ein Metallfilm, der dünn, dicht und glatt ausgeformt sein kann, auf die Kunststofffolie aufgebracht, und somit ein Substrat bereitgestellt, das auch für flexible strahlungsemittierende Vorrichtungen geeignet ist und eine Beschädigung durch Diffusion von Sauerstoff oder Wasser der auf dem Substrat angeordneten organischen Schichten verhindert.

Durch das Einrichten des Metallfilms als erste Elektrode umfasst der Metallfilm die beiden Funktionen, als Elektrode und als Abdichtung der Kunststofffolie ausgestaltet zu sein. Zur Einrichtung des Metallfilms als Elektrode wird der Metallfilm an einen externen elektrischen Anschluss elektrisch leitend angeschlossen und so ausgeformt, dass eine elektrisch leitende Verbindung zu den nachfolgend aufgebrachten organischen funktionellen Schichten hergestellt wird.

In dem Verfahrensschritt A2) kann weiterhin ein Material für den Metallfilm aufgesputtert werden. Vor dem Aufsputtern kann die Kunststofffolie angeätzt werden. Durch das Anätzen wird die Haftung zwischen der Kunststofffolie und dem Metallfilm verbessert und somit die Stabilität des Substrats erhöht. Weiterhin kann in einem Verfahrensschritt A3) zwischen den Verfahrensschritten A1) und A2) auf der Kunststofffolie eine Planarisierungsschicht angeordnet werden. Die Planarisierungsschicht kann dabei so ausgeformt sein, dass sie Oberflächenrauhigkeiten der Kunststofffolie durch geeignete Wahl ihrer Dicke ausgleicht und somit die Anordnung eines glatten Metallfilms auf der Planarisierungsschicht ermöglicht. Die Planarisierungsschicht kann beispielsweise in einer Dicke ausgeformt sein, die aus dem Bereich 1 bis 100 µm ausgewählt ist.

Das Verfahren weist weiterhin einen Verfahrensschritt D), der auf den Verfahrensschritt C) folgt, auf, in dem die im Verfahrensschritt C) bereitgestellte Anordnung mit einer Glas- und/oder Dünnfilmverkapselung verkapselt wird. Damit kann auf dem Substrat eine Verkapselung aufgebracht werden, die die zumindest eine organische funktionelle Schicht zusammen mit dem Metallfilm hermetisch und intrinsisch dicht verkapselt.

Der Verfahrensschritt D) umfasst die Schritte D1) Anordnen einer strukturierten Isolationsschicht auf Bereichen des Substrats, die nicht von der zumindest einen organischen funktionellen Schicht bedeckt sind, D2) Anordnen der Glas- und/oder Dünnfilmverkapselung auf der strukturierten Isolationsschicht und der zweiten Elektrode Damit wird die zumindest eine organische funktionelle Schicht vollständig von der Glas- und/oder Dünnfilmverkapselung umgeben und somit von allen Seiten vor Diffusion von Sauerstoff und/oder Feuchtigkeit geschützt.

Anhand der Figuren und Ausführungsbeispiele sollen einzelne Ausführungsbeispiele die Erfindung noch näher erläutert werden:
- Figur 1: zeigt die schematische Seitenansicht einer flexiblen strahlungsemittierenden Vorrichtung,
- Figur 2: zeigt die schematische Seitenansicht einer herkömmlichen, topemittierenden, strahlungsemittierenden Vorrichtung,
- Figur 3: zeigt die schematische Seitenansicht einer flexiblen strahlungsemittierenden Vorrichtung, die nicht gemäß der Erfindung bereitgestellt ist,
- Figur 4: zeigt die schematische Seitenansicht einer weiteren flexiblen strahlungsemittierenden Vorrichtung, die nicht gemäß der Erfindung bereitgestellt ist,
- Figur 5: zeigt die schematische Seitenansicht einer flexiblen strahlungsemittierenden Vorrichtung, die nicht gemäß der Erfindung bereitgestellt ist,
- Figur 6: zeigt die schematische Seitenansicht einer Ausführungsform der flexiblen strahlungsemittierenden Vorrichtung,
- Figur 7: zeigt die schematische Aufsicht einer Ausführungsform der flexiblen strahlungsemittierenden Vorrichtung,
- Figur 8: zeigt ein Schema zur Diffusionsrate von Sauerstoff und Wasser verschiedener Materialien.

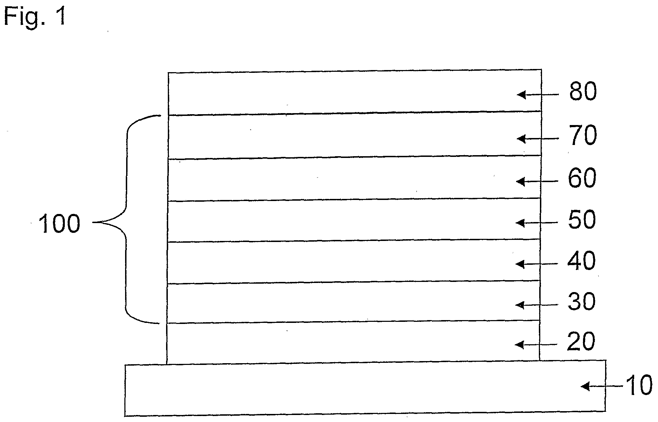

Die folgenden Figuren 1 und 3 bis 7 zeigen Ausführungsformen von flexiblen strahlungsemittierenden Vorrichtungen. Gleichermaßen können die Ausführungsformen auch als nicht flexible Vorrichtungen ausgeformt sein.

Figur 1 zeigt die schematische Seitenansicht einer flexiblen strahlungsemittierenden Vorrichtung, die beispielsweise eine organische Licht emittierende Diode (OLED) sein kann. Diese weist ein Substrat 10, eine erste Elektrode 20, eine Ladungsinjektionsschicht 30, eine Ladungstransportschicht 40, eine erste Licht emittierende Schicht 50, eine zweite Licht emittierende Schicht 60, eine dritte Licht emittierende Schicht 70, und eine zweite Elektrode 80 auf. Die Ladungsinjektionsschicht 30, die Ladungstransportschicht 40, und die erste, zweite und dritte Licht emittierenden Schichten 50, 60 und 70 bilden zusammen die organischen funktionellen Schichten 100. Die erste Elektrode 20 kann beispielsweise eine Anode sein, die zweite Elektrode 80 kann beispielsweise eine Kathode sein. Zwischen Anode und Kathode sind die organischen Schichten angeordnet. Ist die erste Elektrode 20 eine Anode, so ist die Ladungsinjektionsschicht 30 eine Lochinjektionsschicht und die Ladungstransportschicht 40 eine Lochtransportschicht. Die erste Licht emittierende Schicht 50 kann beispielsweise blaues Licht emittieren, die zweite Licht emittierende Schicht 60 kann beispielsweise grünes Licht emittieren und die dritte Licht emittierende Schicht 70 kann beispielsweise rotes Licht emittieren. Weitere Licht emittierende Schichten, oder andere Abfolgen der Farben des emittierten Lichts der verschiedenen Schichten sind ebenso denkbar. Es können im Übrigen weitere organische funktionelle Schichten, wie beispielsweise Elektroneninjektions- und Elektronentransportschichten vorhanden sein.

Eine strahlungsemittierende Vorrichtung kann aber auch einen einfacheren Aufbau aufweisen, und beispielsweise ein Substrat 10, eine erste Elektrode 20, eine Licht emittierende Schicht 50, die Licht in einer beliebigen Farbe emittieren kann, und eine zweite Elektrode 80. Die übrigen in Figur 1 gezeigten Schichten können optional hinzugefügt werden.

Beispielhafte Materialien für diese Schichten sind Indiumzinnoxid (ITO) für die erste Elektrode im Falle einer Anode, 1-TNATA für die Ladungsinjektionsschicht im Falle einer Lochinjektionsschicht, s-TAD für die Ladungstransportschicht im Falle einer Lochtransportschicht, SEB010:SEB020 für eine blaues Licht emittierende Schicht, TMM004:Ir(ppy)₃ (15 %) für eine grünes Licht emittierende Schicht, und TMM-04:TER012 für eine rotes Licht emittierende Schicht. Für die Kathode, beispielsweise die zweite Elektrode, können Metalle, wie beispielsweise Aluminium, Kupfer, Chrom oder Silber ausgewählt werden.

Die von den Elektroden in die organischen funktionellen Schichten injizierten Elektronen und Löcher rekombinieren in den Licht emittierenden Schichten, sodass es zur Emission von Licht kommt. Auf welcher Seite der strahlungsemittierenden Vorrichtung das Licht ausgekoppelt wird, hängt davon ab, ob das Substrat, die erste und die zweite Elektrode transparent ausgeformt sind. Ist das Substrat und die erste Elektrode transparent ausgeformt, handelt es sich um einen Bottom-Emitter, ist die zweite Elektrode und die Verkapselung transparent ausgeformt, handelt es sich um einen Top-Emitter. Es ist weiterhin vorstellbar, dass sowohl Substrat, erste Elektrode als auch zweite Elektrode transparent ausgeformt sind und die Lichtemission über beide Seiten der strahlungsemittierenden Vorrichtung stattfindet.

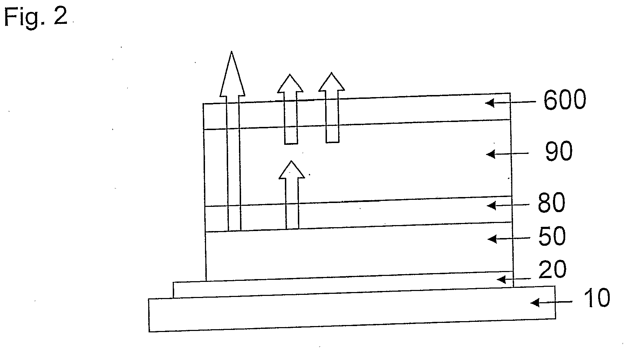

Figur 2 zeigt die schematische Seitenansicht einer topemittierenden, strahlungsemittierenden Vorrichtung. Diese weist ein Substrat 10 auf, auf dem die erste Elektrode 20 angeordnet ist, die Licht emittierende Schicht 50 und die zweite Elektrode 80. Das Substrat umfasst hier ein starres Glas und ist somit nicht flexibel ausgeformt. Durch die Verwendung dieses Substrats ist es notwendig, eine zusätzliche erste Elektrode 20 auf dem Substrat anzuordnen. Das emittierte Licht, das hier durch Pfeile angedeutet wird, wird durch die zweite Elektrode hindurch aus der strahlungsemittierenden Vorrichtung ausgekoppelt, und durch funktionale Schichten 90 sowie einer Dünnfilmverkapselung 600 geleitet. Die funktionalen Schichten können beispielsweise Strahlungskonversionsleuchtstoffe enthalten, um die Wellenlänge des emittierten Lichtes zu verändern. Weiterhin können funktionale Schichten Streustrukturen aufweisen, um die Intensität des Lichtes zu verstärken. Die Dünnfilmverkapselung 600 ist in diesem Fall transparent ausgeformt, sodass die Emission des Lichtes nicht behindert wird. Die Dünnfilmverkapselung dient weiterhin zur Verkapselung der Vorrichtung, damit die organischen Schichten nicht durch Sauerstoff oder Feuchte beschädigt werden. Sie ist schematisch auf der funktionalen Schicht dargestellt, kann jedoch auch die gesamte strahlungsemittierende Vorrichtung umschließen.

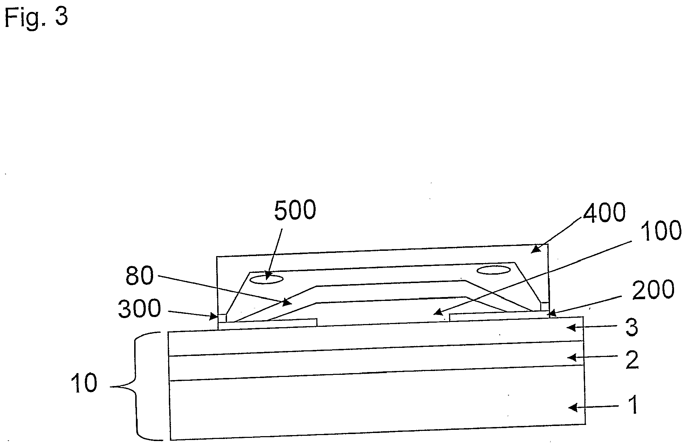

Figur 3 zeigt die schematische Seitenansicht einer flexiblen strahlungsemittierenden Vorrichtung, die nicht gemäß der Erfindung bereitgestellt ist. Diese weist ein Substrat 10 auf, das eine Kunststofffolie 1, eine Planarisierungsschicht 2 und einen Metallfilm 3 umfasst. Die Planarisierungsschicht 2 ist optional vorhanden, je nach Rauhigkeit der Kunststofffolie 1 kann auf sie verzichtet werden. Bei dem Metallfilm 3 handelt es sich um einen intrinsisch und hermetisch dichten Metallfilm, der gleichzeitig als Elektrode für die strahlungsemittierende Vorrichtung ausgeformt ist. Er kann als Anode oder als Kathode eingerichtet sein und strukturiert oder unstrukturiert auf der Kunststofffolie oder auf der Planarisierungsschicht aufgebracht werden. Die Anordnung einer zusätzlichen ersten Elektrode auf dem Substrat ist somit nicht nötig. Die Planarisierungsschicht kann weiterhin auch zur Haftverbesserung zwischen dem Metallfilm 3 und der Kunststofffolie 1 dienen. Das Substrat kann die organischen Schichten vor Feuchtigkeit und Sauerstoff abdichten und dient gleichzeitig als erste Elektrode, an die zur Erzeugung der Strahlungsemission Spannung angelegt werden kann.

Das Substrat 10 weist eine größere Fläche auf, als die darauf folgenden Schichten, sodass an allen Seiten eine Überlappung der Fläche des Substrats 10 über die Fläche der anderen Schichten hinaus vorhanden ist. Auf dem Substrat 10 ist eine strukturierte Isolationsschicht 200 vorhanden, die den direkten Kontakt des Metallfilms 3 und der zweiten Elektrode 80 verhindert. Die Isolationsschicht kann ein Material aufweisen, das aus Al₂O₃, TiO₂, ZrO₂, SiO₂, Si₃N₄, SiC, DLC oder Kombinationen davon ausgewählt ist. Die Isolationsschicht 200 kann beispielsweise eine 100 nm dicke SiO₂-Schicht sein, die in einem PE-CVD-Verfahren hergestellt wird.

Zwischen der strukturierten Isolationsschicht sind die organischen funktionellen Schichten 100 aufgebracht. Auf den organischen funktionellen Schichten 100 befindet sich die zweite Elektrode 80. Mit einem Haftmittel 300 ist eine Glasverkapselung 400 derart auf den organischen Schichten und der zweiten Elektrode 80 aufgebracht, dass eine Kavität zwischen der Glasverkapselung 400 und der zweiten Elektrode 80 entsteht. An den Seitenrändern der Kavität, außerhalb des emittierenden Bereiches der organischen funktionellen Schichten, kann ein Trocknungsmittel 500 vorhanden sein, das eventuell durch das Haftmittel 300 eindiffundierende Feuchtigkeit absorbiert. Beispiele für ein Trocknungsmittel sind Zeolite oder CaO, die in Teflon eingelagert sind. In dieser Ausführungsform wird das Haftmittel 300 auf die Isolationsschicht 200 aufgebracht. Sie kann weiterhin auch auf dem Metallfilm 3 aufgebracht sein.

Das Haftmittel kann ein Material aufweisen, das aus einer Gruppe ausgewählt ist, die Epoxide, Acrylate, Silikone, und lackartige Materialien umfasst.

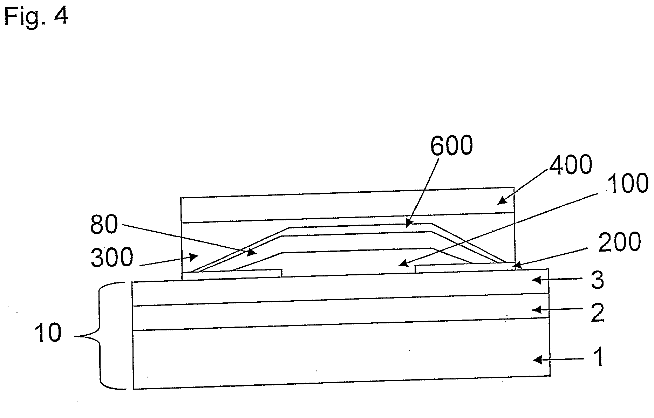

Figur 4 zeigt die schematische Seitenansicht einer weiteren flexiblen strahlungsemittierenden Vorrichtung, die nicht gemäß der Erfindung bereitgestellt ist. Das Substrat 10, die Isolationsschicht 200, die organischen funktionellen Schichten 100 und die zweite Elektrode 80 sind analog der Ausführungsform in Figur 3 ausgeformt. Die Verkapselung umfasst hier eine

Dünnfilmverkapselung 600 sowie eine Glasverkapselung 400. Diese sind wieder mit einem Haftmittel 300 miteinander verbunden.

Die Dünnfilmverkapselung 600 wird direkt auf die zweite Elektrode 80 beispielsweise mittels eines Plasmaprozesses abgeschieden. Es handelt sich dabei um eine transparente dünne Schicht, die hermetisch wasser- und sauerstoffdicht ist. Es kann sich dabei beispielsweise um einen Stapel aus 100 nm dicken SiN_{X}, 50 nm dicken SiO₂ und 100 nm dicken SiN_{X}-Schichten handeln. Auf dieser Dünnfilmverkapselung 600 wird eine mit einem transparenten, lichtbeständigen Haftmittel versehene Glasverkapselung 400 luftblasenfrei auflaminiert.

Haftmittel können beispielsweise Epoxide, Acrylate, Silikone, lackartige Materialien und sonstige klebende Materialien umfassen. Die Aushärtung des Haftmittels kann beispielsweise durch Belichtung, Wärme oder chemische Reaktion in Zweikomponentenklebern erfolgen. Alternativ können auch Haftmittel verwendet werden, die permanent klebrig sind. Das Haftungsmittel kann eine Dicke von 10 µm aufweisen.

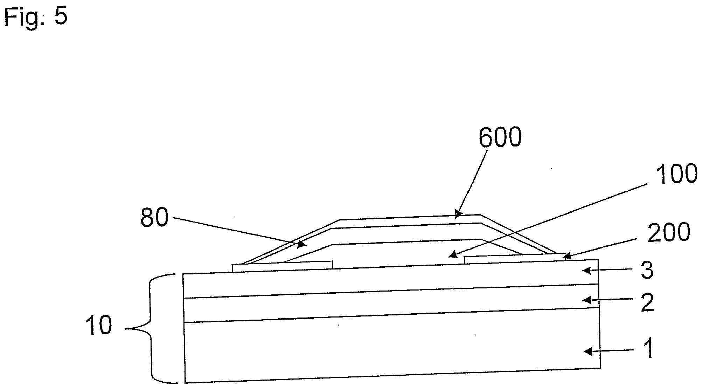

Figur 5 zeigt eine schematische Seitenansicht einer flexiblen strahlungsemittierenden Vorrichtung, die nicht gemäß der Erfindung bereitgestellt ist. Das Substrat 10, die Isolationsschicht 200, die organischen funktionellen Schichten 100 und die zweite Elektrode 80 sind analog der Ausführungsformen in den Figuren 3 und 4 ausgeformt. Im Vergleich zu den Vorrichtungen der Figuren 3 und 4 ist hier eine Verkapselung vorhanden, die lediglich eine Dünnfilmverkapselung 600 umfasst. Diese wird direkt auf die zweite Elektrode 80 beispielsweise durch einen Plasmaprozess als transparente dünne Schicht abgeschieden und ist hermetisch wasserdicht. Die Dünnfilmverkapselung kann beispielsweise einen Schichtstapel aus einer größeren Anzahl von SiN_{X}, SiO₂, SiN_{X}-Schichten umfassen.

In den Ausführungsformen der Figuren 3 bis 5 können weitere funktionale Schichten vorhanden sein (hier nicht gezeigt), die Konversionsleuchtstoffe, Auskoppelstrukturen, Farbfilter, Kratz- und/oder UV-Schutzmaterialien aufweisen. Diese Schichten können sich innerhalb oder außerhalb der Verkapselung befinden.

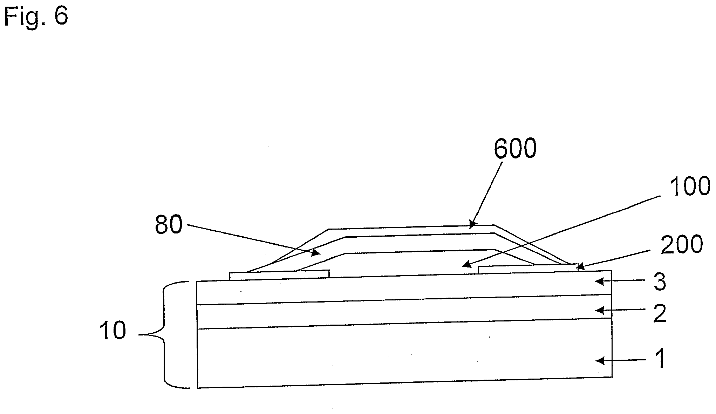

Figur 6 zeigt eine schematische Seitenansicht einer erfindungsgemäßen Ausführungsform der flexiblen strahlungsemittierenden Vorrichtung. In den Figuren 3 bis 5 wurde jeweils eine Verkapselung gezeigt, die die funktionellen Schichten 100 und die zweite Elektrode 80 vollständig umschließt. In Figur 6 ist nun gezeigt, dass die zweite Elektrode 80 aus der Verkapselung, in diesem Fall eine Dünnfilmverkapselung 600, herausragt, um von außen elektrisch angebunden werden zu können. Dazu muss die zweite Elektrode auf der Isolationsschicht 200 aufgebracht sein, um einen Kurzschluss mit der Metallfolie 3 zu verhindern. Die herausführende zweite Elektrode 80 ist auch in den Ausführungsformen gemäß Figuren 3 bis 5 vorhanden, dort aber der Übersichtlichkeit halber nicht gezeigt.

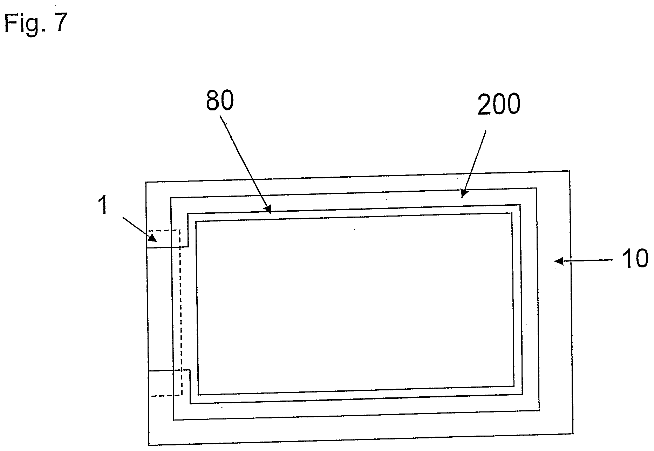

Figur 7 zeigt die Aufsicht auf eine flexible strahlungsemittierende Vorrichtung gemäß einer der Figuren 3 bis 6 mit einem Substrat 10, einer strukturierten Isolationsschicht 200 und einer zweiten Elektrode 80. Das Substrat weist einen Bereich auf, der eine Aussparung des Metallfilms 3 aufweist und in dem die Kunststofffolie 1 frei liegt (angedeutet durch gestrichelte Linie). Dieser Bereich kann zur Isolation zwischen dem Substrat und auf dem Substrat angeordneten Schichten dienen und ist eine Alternative Ausführungsform zu Isolationsschichten, die in diesem Bereich auf die Metallschicht aufgebracht werden können. Die übrigen Schichten wie Planarisierungsschicht 2 und organische funktionelle Schichten 100 sind der Übersichtlichkeit halber nicht gezeigt.

Die Aufsicht soll verdeutlichen, dass die zweite Elektrode 80 aus der Verkapselung 600, die hier nicht gezeigt ist, herausragt, um von außen elektrisch angeschlossen werden zu können. Damit sie nicht mit dem Metallfilm 3 in Kontakt kommt, ist die Isolationsschicht 200 vorhanden. Zusätzlich oder alternativ kann das Substrat 10 in einem Bereich so ausgeführt sein, dass kein Metallfilm 3 vorhanden ist, der mit der zweiten Elektrode in Berührung kommen kann und somit eine Isolation zum Substrat vorhanden ist.

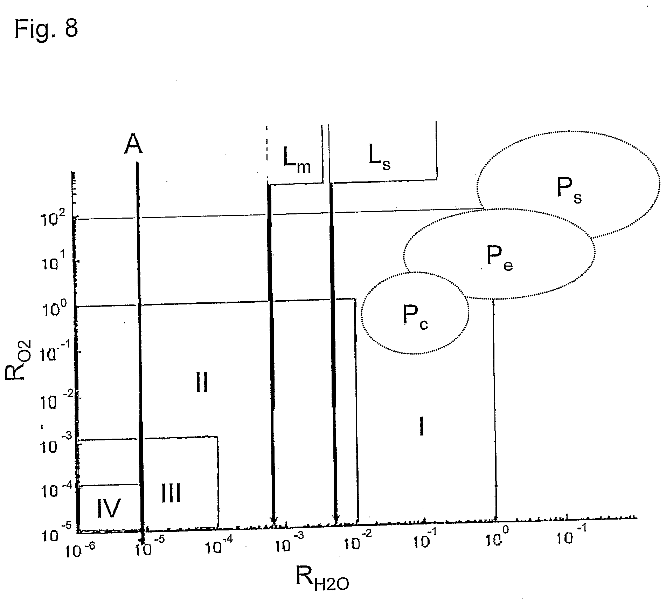

Figur 8 zeigt ein Schema zur Diffusionsrate von Sauerstoff R_{O2} und Wasser R_{H2O} für verschiedene Materialien. Die Diffusionsrate von Sauerstoff R_{O2} ist auf der y-Achse in cm³/m² x d x bar angegeben, die Diffusionsrate R_{H2O} ist auf der x-Achse in g/m² x d angegeben.

P_{S} sind Standardpolymere, P_{E} sind speziell entwickelte Polymere und P_{C} beschichtete Polymere. In dieser Reihenfolge weisen diese Polymere abnehmende Diffusionsraten R_{O2} und R_{H2O} auf. Die Polymere P_{E} und P_{C} können beispielsweise für Schaltflächen, im Automotivbereich oder elektronischen Gebrauchsgeräten verwendet werden. Dieser Bereich der Diffusionsraten wird mit dem Bereich I gekennzeichnet.

Es gibt weiterhin optimierte Monolagen L_{S} und vielschichtige Lagen L_{M}, die noch niedrigere Diffusionsraten, in dem Schema gekennzeichnet durch den Bereich II, als die oben genannten Polymere P_{S}, P_{E} und P_{C} aufweisen. Diese können beispielsweise für Sensoren, Outdoorelektronikgeräten und Weißwaren verwendet werden.

Der Bereich III zeigt den Bereich noch niedrigerer Diffusionsraten R_{O2} und R_{H2O}, der beispielsweise für die Verwendung von organischen Flüssigkristalldioden oder für die Anwendung in der organischen Photovoltaik geeignet ist. Der Bereich IV weist die Diffusionsraten aus, die für die Anwendung von organischen Leuchtdioden geeignet sind. A kennzeichnet Sollwert der Diffusionsrate R_{H2O}, der in einem Material nötig ist, um die Anwendung in OLEDs zu ermöglichen. Dieser Sollwert ist so niedrig, dass die Diffusion mit den üblichen Messmethoden nicht mehr gemessen werden kann. Ein solch niedriger Diffusionswert kann durch die Verwendung des flexiblen Substrats, das eine Kunststofffolie und einen Metallfilm umfasst, erreicht werden.

Die in den Figuren und Ausführungsbeispielen gezeigten Ausführungsformen können beliebig variiert werden.

## Patentansprüche

1. Strahlungsemittierende Vorrichtung aufweisend
- ein Substrat (10),
- zumindest eine organische funktionelle Schicht (100) auf dem Substrat (10) und
- eine zweite Elektrode (80) auf der zumindest einen organischen funktionellen Schicht (100),
- eine Glas- und/oder Dünnfilmverkapselung auf der zweiten Elektrode, zur Verkapselung der zumindest einen organischen funktionellen Schicht,
wobei das Substrat (10) eine Kunststofffolie (1) und einen diffusionsdichten Metallfilm (3) umfasst und der Metallfilm (3) zwischen der Kunststofffolie (1) und der zumindest einen organischen funktionellen Schicht (100) angeordnet und als erste Elektrode eingerichtet ist, wobei das Substrat (10) frei von Barriereschichten ist, **dadurch gekennzeichnet, dass** zwischen der Glas- und/oder Dünnfilmverkapselung (400, 600) und dem Substrat (10) eine strukturierte Isolationsschicht (200) angeordnet ist,
wobei die zweite Elektrode (80) zumindest auch auf der Isolationsschicht (200) aufgebracht ist,
wobei die zweite Elektrode (80) über die Glas- und/oder Dünnfilmverkapselung (400, 600) hin-ausragt, um von außen elektrisch angebunden werden zu können,
wobei die Isolationsschicht über die Glas- und/oder Dünnfilmverkapselung hinausragt,
wobei die zweite Elektrode eine erste schräge Flanke und eine zweite schräge Flanke aufweist, wobei die erste und zweite schräge Flanke bündig und schräg auf der Isolationsschicht aufgebracht ist, wobei die erste schräge Flanke über die Glas- und/oder Dünnfilmverkapselung (400, 600) hinausragt, und wobei die zweite schräge Flanke nicht über die Glas- und/oder Dünnfilmverkapselung (400, 600) hinausragt.

2. Strahlungsemittierende Vorrichtung nach dem vorhergehenden Anspruch, wobei das Substrat (10) flexibel ist.

3. Strahlungsemittierende Vorrichtung nach einem der vorhergehenden Ansprüche, wobei das Substrat (10) eine größere laterale Ausdehnung aufweist als die zumindest eine organische funktionelle Schicht (100) und die zweite Elektrode (80).

4. Strahlungsemittierende Vorrichtung nach einem der vorhergehenden Ansprüche, wobei die Kunststofffolie (1) weniger diffusionsdicht als der Metallfilm (3) ist.

5. Strahlungsemittierende Vorrichtung nach einem der vorhergehenden Ansprüche, wobei der Metallfilm (3) zumindest zwei Teilschichten aufweist.

6. Strahlungsemittierende Vorrichtung nach einem der vorhergehenden Ansprüche, wobei zwischen der Kunststofffolie (1) und dem Metallfilm (3) eine Planarisierungsschicht (2) angeordnet ist.

7. Verfahren zur Herstellung einer flexiblen strahlungsemittierenden Vorrichtung nach einem der Ansprüche 1 bis 6, mit den Verfahrensschritten
A) Bereitstellen einer Kunststofffolie (1) und eines Metallfilms (3) zur Herstellung eines Substrats (10),
B) Einrichten des Metallfilms (3) als erste Elektrode,
C) Anordnen zumindest einer organischen funktionellen Schicht (100) und einer zweiten Elektrode (80) auf dem Substrat (10),
D1) Anordnen einer strukturierten Isolationsschicht (200) auf Bereichen des Substrats (10), die nicht von der zumindest einen organischen funktionellen Schicht (100) bedeckt sind, und
D2) Anordnen der Glas- und/oder Dünnfilmverkapselung (400, 600) über der strukturierten Isolationsschicht (200) und der zweiten Elektrode (80).

8. Verfahren nach dem vorhergehenden Anspruch, wobei der Verfahrensschritt A) die Schritte
A1) Herstellen einer Kunststofffolie (1), und
A2) Anordnen eines Metallfilms (3) auf der Kunststofffolie (1) umfasst.

9. Verfahren nach Anspruch 8, wobei im Verfahrensschritt A2) ein Material für den Metallfilm (3) auf die Kunststofffolie (1) aufgedampft oder aufgesputtert wird.

10. Verfahren nach einem der Ansprüche 8 bis 9, wobei in einem Verfahrensschritt A3) zwischen den Verfahrensschritten A1) und A2) auf der Kunststofffolie (1) eine Planarisierungsschicht (2) angeordnet wird.

11. Verfahren nach einem der Ansprüche 8 bis 10, aufweisend einen auf den Verfahrensschritt C) folgenden Verfahrensschritt D), in dem die im Verfahrensschritt C) bereitgestellte Anordnung mit einer Glas- und/oder Dünnfilmverkapselung (400, 600) verkapselt wird.

## Claims

1. Radiation-emitting device having
- a substrate (10),
- at least one organic functional layer (100) on the substrate (10), and
- a second electrode (80) on the at least one organic functional layer (100),
- a glass and/or thin-film encapsulation on the second electrode for encapsulating the at least one organic functional layer,
wherein the substrate (10) comprises a plastic film (1) and a diffusion-proof metal film (3), and the metal film (3) is arranged between the plastic film (1) and the at least one organic functional layer (100) and is set up as a first electrode, wherein the substrate (10) is free of barrier layers,
**characterized in that**
a structured insulation layer (200) is arranged between the glass and/or thin-film encapsulation (400, 600) and the substrate (10),
wherein the second electrode (80) is applied at least also to the insulating layer (200),
wherein the second electrode (80) projects beyond the glass and/or thin-film encapsulation (400, 600) in order to be electrically connectable from the outside,
wherein the insulation layer projects beyond the glass and/or thin-film encapsulation,
wherein the second electrode has a first oblique edge and a second oblique edge, wherein the first and second oblique edge is applied flush and obliquely to the insulating layer, wherein the first oblique edge projects beyond the glass and/or thin-film encapsulation (400, 600), and wherein the second oblique edge does not project beyond the glass and/or thin-film encapsulation (400, 600).

2. Radiation emitting device according to the preceding claim, wherein the substrate (10) is flexible.

3. Radiation emitting device according to one of the preceding claims, wherein the substrate (10) has a larger lateral extent than the at least one organic functional layer (100) and the second electrode (80).

4. Radiation emitting device according to one of the preceding claims, wherein the plastic film (1) is less diffusion-proof than the metal film (3).

5. Radiation emitting device according to one of the preceding claims, wherein the metal film (3) comprises at least two sublayers.

6. Radiation emitting device according to one of the preceding claims, wherein a planarization layer (2) is arranged between the plastic film (1) and the metal film (3).

7. Method for producing a flexible radiation-emitting device according to one of claims 1 to 6, comprising the steps of
A) providing a plastic film (1) and a metal film (3) for producing a substrate (10),
B) setting up the metal film (3) as first electrode,
C) arranging at least one organic functional layer (100) and a second electrode (80) on the substrate (10),
D1) arranging a structured insulating layer (200) on regions of the substrate (10), which are not covered by the at least one organic functional layer (100), and
D2) arranging the glass and/or thin-film encapsulation (400, 600) over the structured insulation layer (200) and the second electrode (80).

8. Method according to the preceding claim, wherein the method step A) comprises the steps of
A1) manufacturing a plastic film (1), and
A2) arranging a metal film (3) on the plastic film (1).

9. Method according to claim 8, wherein in method step A2) a material for the metal film (3) is evaporated or sputtered onto the plastic film (1).

10. Method according to one of the claims 8 to 9, wherein in a process step A3) a planarization layer (2) is arranged on the plastic film (1) between the process steps A1) and A2).

11. Method according to one of the claims 8 to 10,, having a method step D) following method step C), in which the arrangement provided in method step C) is encapsulated with a glass and/or thin-film encapsulation (400, 600).

## Revendications

1. Dispositif émetteur de rayonnement, présentant
- un substrat (10),
- au moins une couche fonctionnelle organique (100) sur le substrat (10) et
- une seconde électrode (80) sur d'au moins une couche fonctionnelle organique (100),
- une encapsulation en verre et/ou à pellicule fine sur la seconde électrode, en vue d'encapsulation d'au moins une couche fonctionnelle organique,
sachant que le substrat (10) comporte une feuille en plastique (1) et une pellicule métallique étanche à la diffusion (3) et que la pellicule métallique (3) est disposée entre la feuille en plastique (1) et d'au moins une couche fonctionnelle organique (100) et configurée comme première électrode, sachant que le substrat (10) est exempt de couches barrières, **caractérisé en ce que**
entre l'encapsulation en verre et/ou à pellicule fine (400, 600) et le substrat (10) est disposée une couche d'isolation structurée (200),
sachant que la seconde électrode (80) est appliquée au moins également sur la couche d'isolation (200),
sachant que la seconde électrode (80) fait saillie au-dessus de l'encapsulation en verre et/ou à pellicule fine (400, 600) afin de pouvoir être raccordée électriquement par l'extérieur,
sachant que la couche d'isolation fait saillie au-dessus de l'encapsulation en verre et/ou à pellicule fine,
sachant que la deuxième électrode présente un premier flanc incliné et un second flanc incliné, sachant que le premier et le second flanc incliné est appliqué à fleur et en position inclinée sur la couche d'isolation, sachant que le premier flanc incliné fait saillie au-dessus de l'encapsulation en verre et/ou à pellicule fine (400, 600), et sachant que le second flanc incliné ne fait pas saillie au-dessus de l'encapsulation en verre et/ou à pellicule fine (400, 600).

2. Dispositif émetteur de rayonnement selon la revendication précédente,
sachant que le substrat (10) est flexible.

3. Dispositif émetteur de rayonnement selon une quelconque des revendications précédentes,
sachant que le substrat (10) présente une plus grande extension latérale que d'au moins une couche fonctionnelle organique (100) et la seconde électrode (80).

4. Dispositif émetteur de rayonnement selon une quelconque des revendications précédentes,
sachant que la feuille en plastique (1) est moins étanche à la diffusion que la pellicule métallique (3).

5. Dispositif émetteur de rayonnement selon une quelconque des revendications précédentes,
sachant que la pellicule métallique (3) présente au moins deux couches partielles.

6. Dispositif émetteur de rayonnement selon une quelconque des revendications précédentes,
sachant qu'entre la feuille en plastique (1) et la pellicule métallique (3) est disposée une couche de planarisation (2).

7. Procédé en vue de la fabrication d'un dispositif flexible émetteur de rayonnement selon une quelconque des revendications 1 à 6,
avec les étapes de procédé de
A) mise à disposition d'une feuille en plastique (1) et d'une pellicule métallique (3) en vue de la fabrication d'un substrat (10),
B) configuration de la pellicule métallique (3) comme première électrode,
C) disposition d'au moins une couche fonctionnelle organique (100) et d'une seconde électrode (80) sur le substrat (10),
D1) disposition d'une couche d'isolation structurée (200) sur des zones du substrat (10), qui ne sont pas couvertes par d'au moins unecouche fonctionnelle organique (100), et
D2) disposition de l'encapsulation en verre et/ou à pellicule fine (400, 600) sur la couche d'isolation structurée (200) et la seconde électrode (80).

8. Procédé selon la revendication précédente,
sachant que l'étape de procédé A) comporte les étapes de
A1) fabrication d'une feuille en plastique (1), et
A2) disposition d'une pellicule métallique (3) sur la feuille en plastique (1).

9. Procédé selon la revendication 8,
sachant qu'à l'étape de procédé A2), une matière pour la pellicule métallique (3) est appliquée par vaporisation ou par pulvérisation sur la feuille en plastique (1).

10. Procédé selon une quelconque des revendications 8 à 9,
sachant qu'à une étape de procédé A3) entre les étapes de procédé A1) et A2) est disposée une couche de planarisation (2) sur la feuille en plastique (2).

11. Procédé selon une quelconque des revendications 8 à 10, présentant une étape de procédé D) suivant l'étape de procédé C), dans laquelle la disposition préparée à l'étape de procédé C) est blindée avec un blindage en verre et/ou à pellicule fine (400, 600).
